# EUROPEAN PATENT APPLICATION

(11) **EP 4 686 101 A1**
(43) Date of publication of application: **28.01.2026**
(21) Application number: 25190375.3
(22) Date of filing: 18.07.2025
(51) Int. Cl.: H03L 7/08

(54) **DUTY CYCLE CALIBRATION CIRCUIT, DUTY CYCLE CALIBRATION METHOD, AND CLOCK MULTIPLIER CIRCUIT**

(30) Priority: 25.07.2024 CN 202411011476
(71) Applicant: Amlogic (Shanghai) Co., Ltd., Shanghai 201315 (CN)
(72) Inventor: ZOU, Weihua, Shanghai (CN); ZHANG, Yaozhong, Shanghai (CN); WU, Shuo, Shanghai (CN)
(74) Representative: Maiwald GmbH

(57) **Abstract**

Provided a duty cycle calibration circuit, method and clock multiplier circuit, wherein the duty cycle calibration circuit generates a delay-matched clock signal that is aligned with the first edge of the calibration clock signal and has the same duty cycle as the calibration clock signal through a delay matching cell, and generates a feedback clock signal that is aligned with the first edge of the calibration clock signal and has the target duty cycle through a phase-locked loop cell when the phase-locked loop cell is in the locked state, thereby performing sampling processing on the delay-matched clock signal using the feedback clock signal through the calibration control cell when the phase-locked loop cell is in the locked state, can acquire a sampled signal is used to instruct the relationship between the duty cycle of the calibration clock signal and the target duty cycle, this enable the calibration control cell to generate a calibration control signal according to the sampled signal, thereby calibrating the duty cycle of the calibration clock signal to the target duty cycle, the accuracy of the generated calibration clock signal can be improved.

## Description

### CROSS-REFERENCE TO RELATED APPLICATIONS

This application claims priority to Chinese Patent Application No. 202411011476.5, filed on July 25, 2024.

### TECHNICAL FIELD

The disclosure relates to the technical field of circuits, and in particular to a duty cycle calibration circuit, duty cycle calibration method, and clock multiplier circuit.

### BACKGROUND

In the field of wireless communication, frequency synthesizers based on phase-locked loop structures are widely used to generate oscillation signals, wherein, the phase noise performance of the oscillation signals affects the quality of the communication signals directly.

Currently, the main approach is to increase the frequency of the phase-locked loop reference clock signal through clock multiplier technology, thereby improving the phase noise performance of the phase-locked loop.

Therefore, it is a pressing issue that how to improve the stability of the duty cycle of the reference clock signal in the duty cycle calibration circuit, reduce external interference, and thereby enhancing the output accuracy of the duty cycle calibration circuit.

### SUMMARY

The problem solved by the embodiments of the disclosure is to provide a duty cycle calibration circuit, duty cycle calibration method, and clock multiplier circuit, that can calibrate the duty cycle of the calibration clock signal to the target duty cycle, thereby improving the accuracy of the generated calibration clock signal.

To solve the above technical problems, the embodiment of the disclosure provides a duty cycle calibration circuit, comprising:
a duty cycle calibration cell, configured to perform duty cycle calibration processing on the input clock signal according to the calibration control signal, until the duty cycle of the output calibration clock signal reaches the target duty cycle;
a delay matching cell, configured to perform delay matching processing on the calibration clock signal to acquire a delay-matched clock signal, the first edge of the delay-matched clock signal is aligned with the first edge of the calibration clock signal, and the delay-matched clock signal has the same duty cycle as the calibration control signal;
a phase-locked loop cell, configured to perform phase-locked processing on the calibration clock signal to acquire oscillating clock signal; and to perform frequency division processing on the oscillating clock signal to acquire feedback clock signal; when the phase-locked loop cell is in the locked state, the first edge of the feedback clock signal is aligned with the first edge of the delay-matched clock signal, and the feedback clock signal has the target duty cycle;
a calibration control cell, configured to perform sampling processing on delay-matched clock signal using the feedback clock signal to acquire the sampled signal when the phase-locked loop cell is in the locked state; According to the sampled signal, generate the calibration control signal.

Optionally, the duty cycle calibration cell comprises:
a first delay block, configured to perform the first delay processing on the input clock signal to acquire a first delay clock signal;
a first OR operation block, configured to perform OR operations on the input clock signal and the first delay clock signal to acquire the summed clock signal;
a first inverter, configured to perform inversion processing on the summed clock signal to acquire the inverted signal of the summed clock signal;
a second delay block, configured to perform a second delay processing on the inverted signal of the summed clock signal according to calibration control signal to acquire a second delay clock signal;
a second OR operation block, configured to perform OR operation processing on the inverted signal of the summed clock signal and the second delay clock signal to acquire the calibration clock signal.

Optionally, the phase-locked loop cell comprises:
a phase-frequency detector block, configured to acquire the phase difference signal according to the phase difference between the calibration clock signal and the feedback clock signal;
a charge pump block, configured to convert the phase difference signal into a current signal;
a loop filter block, configured to perform low-pass filter processing on the current signal ;
a voltage-controlled oscillator block, configured to acquire oscillation clock signal according to the current signal;
a first frequency divider block, configured to perform frequency division processing on the oscillating clock signal to acquire the feedback clock signal.

Optionally, the first frequency divider block comprises:
a first frequency divider, configured to perform the first sub frequency division processing on the oscillating clock signal to acquire the first frequency-divided signal;
a second frequency divider, configured to perform the second sub frequency division processing on the first frequency-divided signal to acquire the feedback clock signal.

Optionally, the first frequency divider is a step frequency divider with a step value of 1/2 ⁿ,and the second frequency divider is a frequency divider-by-2, wherein n is an integer.

Optionally, the calibration control cell comprises:
a sampling block, configured to perform sampling processing on the delay-matched clock signal using the feedback clock signal when the phase-locked loop cell is in the locked state to acquire the sampled signal;
a control block, configured to generate the calibration control signal according to the sampled signal.

Optionally, the sampling block comprises:
a D Flip-Flop, configured to perform sampling processing on the delay-matched clock signal when the second edge of the feedback clock signal arrives, to acquire the sampled signal.

Optionally, the first edge is the rising edge, and the second edge is the falling edge.

Optionally, the control block, configured to acquire the sampled values of the sampled signal according to a preset control period; If the sampled values of the sampled signal within the control period are all the first value, then generate a calibration control signal to instruct the duty cycle calibration cell to increase the duty cycle of the calibration clock signal; If the sampled values of the sampled signal within the control period are all the second value, then generate a calibration control signal to instruct the duty cycle calibration cell to reduce the duty cycle of the calibration clock signal.

Optionally, the calibration control signal comprises: multiple coarse adjustment step control signals corresponding to multiple coarse adjustment steps and multiple fine adjustment step control signals corresponding to multiple fine adjustment steps, and the step interval between adjacent coarse adjustment step is greater than the step interval between adjacent fine adjustment step;

The control block, configured to generate a coarse adjustment step control signal corresponding to the coarse adjustment step according to the sampled signal and output it to the duty cycle calibration cell, until the duty cycle of the calibration clock signal oscillates back and forth near the target duty cycle; and further configured to generate a coarse adjustment step control signal corresponding to the fine adjustment step according to the sampled signal and output it to the duty cycle calibration cell after the duty cycle of the calibration clock signal oscillates back and forth around the target duty cycle, until the duty cycle of the calibration clock signal reaches the target duty cycle.

Optionally, the control block, further configured to perform duty cycle calibration processing on the input clock signal according to the calibration control signal, that when the duty cycle of the output calibration control signal reaches the target duty cycle to acquire and store the corresponding coarse adjustment calibration control signal and the corresponding fine adjustment calibration control signal; and further configured to transmit the stored coarse adjustment calibration control signal and fine adjustment calibration control signal to the duty cycle calibration cell when receiving a wake-up signal;

The duty cycle calibration cell, further configured to calibrate the duty cycle of the calibration clock signal to the target duty cycle according to the received coarse adjustment calibration control signal and fine adjustment calibration control signal, when receiving the coarse adjustment calibration control signal and fine adjustment calibration control signal sent by the calibration control cell.

Optionally, the control block comprises a digital frequency multiplier with a low-pass filter.

Optionally, the phase-locked loop cell, further comprises: a third frequency divider block, configured to perform the third frequency division processing on the oscillation clock signal to acquire a third frequency-divided signal;

The calibration control cell, further comprises: a timing control block, configured to perform a third delay processing on the delay-matched clock signal according to the third frequency-divided signal to acquire a timing control signal, the frequency of the timing control signal is higher than the frequency of the feedback clock signal, and the phase of the timing control signal lags behind the phase of the feedback clock signal; Control the output timing of the calibration control signal according to the timing control signal;

The control block, further configured to control the output timing of the calibration control signal according to the timing control signal.

Optionally, the timing control block comprises a time delay unit.

Optionally, the duty cycle calibration circuit further comprises: a signal selection cell , configured to perform duty cycle calibration processing on the input clock signal according to the calibration control signal, until before the duty cycle of the output calibration control signal reaches the target duty cycle, according to the duty cycle selection control signal, selecting the initial clock signal with a output duty cycle greater than the target duty cycle or the inverted signal of the initial clock signal as the input clock signal;

The delay matching cell, further configured to perform initial delay matching processing on the initial clock signal to acquire an initial delay-matched signal, wherein the first edge of the initial delay-matched clock signal is aligned with the first edge of the initial clock signal, and the delay-matched clock signal has the same duty cycle as the initial clock signal;

The phase-locked loop cell, further configured to perform phase-locked processing on the initial clock signal to acquire the initial oscillation clock signal, perform frequency division processing on the initial oscillation clock signal to acquire the initial feedback clock signal; when the phase-locked loop cell is in the locked state, the first edge of the initial feedback clock signal is aligned with the first edge of the initial delay-matched clock signal and has the target duty cycle;

The calibration control cell, further configured to perform initial sampling processing on the initial delay-matched clock signal using the initial feedback clock signal when the phase-locked loop cell is in the locked state, to acquire an initial sampled signal, wherein the initial sampled signal is used to instruct the relationship between the duty cycle of the initial clock signal and the target duty cycle; and according to the initial sampled signal, generate the duty cycle selection control signal.

Optionally, the calibration control cell, further configured to generate a mode selection control signal with a first logic level before generating the duty cycle selection control signal; and to generate a mode selection control signal with a second logic level after generating the duty cycle selection control signal, wherein the second logic level is different from the first logic level;

The duty cycle calibration cell, configured to perform duty cycle calibration processing on the input clock signal according to the calibration control signal when the mode selection control signal has a second logic level, until the duty cycle of the output calibration control signal reaches the target duty cycle; and further configured to pass the initial clock signal through to the phase-locked loop cell and the delay matching cell when the mode selection control signal has a first logic level.

Optionally, the signal selection cell, configured to select and output the initial clock signal as the input clock signal when the duty cycle selection control signal has a first logic level; select and output the inverted signal of the initial clock signal as the input clock signal, when the duty cycle selection control signal has a second logic level;

The calibration control cell, further configured to convert the logic level of the duty cycle selection control signal from the first logic level to the second logic level when determine that the duty cycle of the initial clock signal is greater than the target duty cycle and the duty cycle selection control signal has the second logic level, and waiting for the phase-locked loop cell reenters the initial locked state, then converting the logic level of the mode selection control signal from the first logic level to the second logic level.

Optionally, the signal selection cell comprises:
The first inverter, configured to perform a first inversion processing on the initial clock signal to acquire an inverted signal of the initial clock signal;
A multiplexer, configured to select a signal with a duty cycle greater than the target duty cycle from the initial clock signal and the inverted signal of the initial clock signal as the input clock signal and output it according to a preset duty cycle selection control signal.

Optionally, the target duty cycle is 50%.

Correspondingly, a duty cycle calibration method is provided by the embodiments of the disclosure, comprising:
Performing delay matching processing on the calibration clock signal to acquire a delay-matched clock signal, wherein the first edge of the delay-matched clock signal is aligned with the first edge of the calibration clock signal, and the delay-matched clock signal has the same duty cycle as the calibration clock signal;
Performing phase-locked processing on the calibration clock signal to acquire an oscillation clock signal; Performing frequency division processing on the oscillation clock signal to acquire a feedback clock signal; When the phase-locked loop cell is in the locked state, the first edge of the feedback clock signal is aligned with the first edge of the delay-matched clock signal and has the target duty cycle;
When the phase-locked loop cell is in the locked state, using the feedback clock signal to perform sampling processing on the delay-matched clock signal to acquire the sampled signal; Generate the calibration control signal according to the sampled signal;
Performing duty cycle calibration processing on the input clock signal according to the calibration control signal, until the duty cycle of the output calibration control signal reaches the target duty cycle.

Correspondingly, a clock multiplier circuit is provided by the embodiments of the disclosure, comprising the duty cycle calibration circuit according to any one of the preceding.

Compared with the prior art, the technical solution of the disclosure embodiment has the following advantages:
The embodiment of the disclosure provides a duty cycle calibration circuit, comprising:
a duty cycle calibration cell, configured to perform duty cycle calibration processing on the input clock signal according to the calibration control signal, until the duty cycle of the output calibration clock signal reaches the target duty cycle; a delay matching cell, configured to perform delay matching processing on the calibration clock signal to acquire a delay-matched clock signal, the first edge of the delay-matched clock signal is aligned with the first edge of the calibration clock signal, and the delay-matched clock signal has the same duty cycle as the calibration control signal; a phase-locked loop cell, configured to perform phase-locked processing on the calibration clock signal to acquire oscillating clock signal; and to perform frequency division processing on the oscillating clock signal to acquire feedback clock signal; when the phase-locked loop cell is in the locked state, the first edge of the feedback clock signal is aligned with the first edge of the delay-matched clock signal, and the feedback clock signal has the target duty cycle; a calibration control cell, configured to perform sampling processing on delay-matched clock signal using the feedback clock signal to acquire the sampled signal when the phase-locked loop cell is in the locked state; According to the sampled signal, generate the calibration control signal.

**In** the duty cycle calibration circuit of the embodiment of the disclosure, generating a delay-matched clock signal that is aligned with the first edge of the calibration clock signal and has the same duty cycle as the calibration clock signal through the delay matching cell, and generating a feedback clock signal that is aligned with the first edge of the calibration clock signal and has the target duty cycle through the phase-locked loop cell when the phase-locked loop cell is in the locked state, thereby performing the sampling on the delay-matched clock signal using the feedback clock signal through the calibration control cell when the phase-locked loop cell is in the locked state, can acquire the sampled signal which used to instruct the relationship between the duty cycle of the calibration clock signal and the target duty cycle, thereby enabling the duty cycle calibration cell to calibrate the duty cycle of the calibration clock signal to the target duty cycle according to the calibration control signal generated by the calibration control cell according to the sampled signal, that can overcome duty cycle offsets of the calibration clock signal caused by process, voltage, and temperature variations, and helps improve the accuracy of the generated calibration clock signal.

### BRIEF DESCRIPTION OF THE DRAWINGS

FIG. 1 is a circuit structure diagram in an embodiment of the duty cycle calibration circuit provided by the technical solution of the disclosure.
FIG. 2 is a waveform diagram of relevant signals in an embodiment of the duty cycle calibration circuit provided by the technical solution of the disclosure.
FIG. 3 is a schematic diagram of duty cycle variation of the calibration clock signal in an embodiment of the duty cycle calibration circuit provided by the technical solution of the disclosure.
FIG. 4 is a circuit structure diagram in another embodiment of the duty cycle calibration circuit provided by the technical solution of the disclosure.
FIG. 5 is a schematic flowchart in an embodiment of a duty cycle calibration method provided by the technical solution of the disclosure.

### DETAILED DESCRIPTION

As can be seen from the background technology, the accuracy of the calibration clock signal and the frequency-multiplied clock signal generated by the duty cycle calibration circuit still needs to be improved, which affects the quality of wireless communication.

To solve the above technical problems, the embodiment of the disclosure provides a duty cycle calibration circuit, comprising: a duty cycle calibration cell, configured to perform duty cycle calibration processing on the input clock signal according to the calibration control signal, until the duty cycle of the output calibration clock signal reaches the target duty cycle; a delay matching cell, configured to perform delay matching processing on the calibration clock signal to acquire a delay-matched clock signal, the first edge of the delay-matched clock signal is aligned with the first edge of the calibration clock signal, and the delay-matched clock signal has the same duty cycle as the calibration control signal; a phase-locked loop cell, configured to perform phase-locked processing on the calibration clock signal to acquire oscillating clock signal; and to perform frequency division processing on the oscillating clock signal to acquire feedback clock signal; when the phase-locked loop cell is in the locked state, the first edge of the feedback clock signal is aligned with the first edge of the delay-matched clock signal, and the feedback clock signal has the target duty cycle; a calibration control cell, configured to perform sampling processing on delay-matched clock signal using the feedback clock signal to acquire the sampled signal when the phase-locked loop cell is in the locked state; According to the sampled signal, generate the calibration control signal.

In the duty cycle calibration circuit of the embodiment of the disclosure, generating a delay-matched clock signal that is aligned with the first edge of the calibration clock signal and has the same duty cycle as the calibration clock signal through the delay matching cell, and generating a feedback clock signal that is aligned with the first edge of the calibration clock signal and has the target duty cycle through the phase-locked loop cell when the phase-locked loop cell is in the locked state, thereby performing the sampling on the delay-matched clock signal using the feedback clock signal through the calibration control cell when the phase-locked loop cell is in the locked state, can acquire the sampled signal which used to instruct the relationship between the duty cycle of the calibration clock signal and the target duty cycle, thereby enabling the duty cycle calibration cell to calibrate the duty cycle of the calibration clock signal to the target duty cycle according to the calibration control signal generated by the calibration control cell according to the sampled signal, that can overcome duty cycle offsets of the calibration clock signal caused by process, voltage, and temperature variations, and helps improve the accuracy of the generated calibration clock signal.

To make the above objectives, features, and advantages of the disclosure more obvious and understandable, specific embodiments of the disclosure are described in detail below with reference to the accompanying drawings.

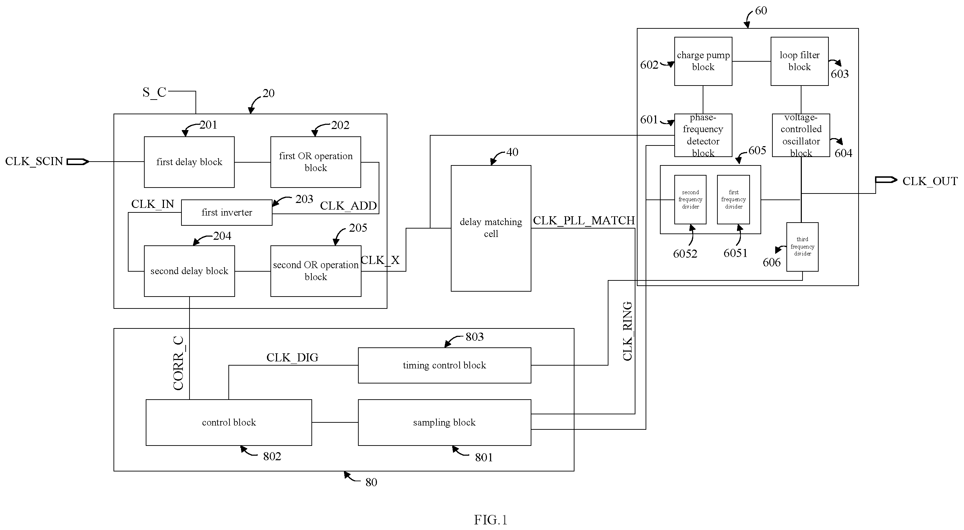

FIG. 1 is a circuit structure diagram in an embodiment of the duty cycle calibration circuit provided by the technical solution of the disclosure.

With reference to FIG. 1, a duty cycle calibration circuit comprising: a duty cycle calibration cell 20, a delay matching cell 40, a phase-locked loop cell 60 and a calibration control cell 80.Wherein, the duty cycle calibration cell 20 is respectively coupled to the delay matching cell 40, the phase-locked loop cell 60 and the calibration control cell 80, , the delay matching cell 40 and the phase-locked loop cell 60 are also respectively coupled to the calibration control cell 80.

In this embodiment, the duty cycle calibration cell 20 is provided with control port, input port, output port. Wherein, the calibration control port of the duty cycle calibration cell 20 is coupled to the calibration control cell 80, the input port of the duty cycle calibration cell 20 configured to receive the input clock signal CLK_SCIN, the output port of the duty cycle calibration cell 20 are respectively coupled to the delay matching cell 40 and the phase-locked loop cell 60.The duty cycle calibration cell 20 configured to perform the duty cycle calibration processing on the input clock signal CLK_SCIN according to the calibration control signal CORR_C, until the duty cycle of the output calibration clock signal CLK_X reaches the target duty cycle.

Specifically, the duty cycle calibration cell 20 comprising: a first delay block 201,a first OR operation block 202, a first inverter 203, a second delay block 204 and a second OR operation block 205.Wherein:
The first delay block 201 is provided with an input port, a first output port and a second output port. Wherein, the input port of the first delay block 201 is used as the input port of the duty cycle calibration cell 20 or coupled to the input port of the duty cycle calibration cell 20, the first output port of the first delay block 201 is coupled to the first input port of the first OR operation block 202, the second output port of the first delay block 201 is coupled to the second input port of the first OR operation block 202. The first delay block 201 configured to perform a first delay processing on the input clock signal CLK_SCIN to acquire the first delayed clock signal.

The first OR operation block 202 is provided with a first input port, a second input port, and an output port. Wherein, the first input port of the first OR operation block 202 is coupled to the first output port of the first delay block 201, the second input port of first OR operation block 202 is coupled to the second output port of the second delay block 201, the output port of the first OR operation block 202 is coupled to the input port of the first inverter 203. The first OR operation block 202 configured to perform OR operation processing on the input clock signal CLK_SCIN and the first delay signal to acquire the summed clock signal CLK_ADD.

The first inverter 203 is provided with an input port and an output port. Wherein, the input port of the first inverter 203 is coupled to the output port of the first OR operation block 202, the output port of the first inverter 203 is coupled to the first input port and the second input port of the second delay block 204.The first inverter 203 configured to perform inversion processing on the summed clock signal to acquire the inverted signal CLK_IN of the summed clock signal.

The second delay block 204 is provided with a first input port, a second input port, a first output port, and a second output port. Wherein, the first input port and second input port of the second delay block 204 are respectively coupled to the output ports of the first inverter 203, the first output port of the second delay block 204 is coupled to the first input port of the second OR operation block 205, the second output port of the second delay block 204 is coupled to the second input port of the second OR operation block 205. The second delay block 204 configured to perform a second delay processing on the inverted signal CLK_IN of the summed clock signal according to the calibration control signal CORR_C to acquire a second delay clock signal.

The second OR operation block 205 is provided with a first input port, a second input port and an output port. Wherein, the first input port and second input port of the second OR operation block 205 are respectively coupled to the output port of the first inverter 203, the output port of the second OR operation block 205 is used as the output port of the duty cycle calibration cell 20 or coupled to the output port of the duty cycle calibration cell 20. The second OR operation block 205 configured to perform OR operation processing on the inverted signal CLK_IN of the summed clock signal and the second delay clock signal to acquire the calibration clock signal CLK_X.

Those skilled in the art will understand that the duty cycle calibration cell may also be implemented through other structures with the same functions, which will not be limited herein.

In this embodiment, the delay matching cell 40 is provided with an input port and an output port. The input port of the delay matching cell 40 is coupled to the output port of the duty cycle calibration cell 20, the output port of the delay matching cell 40 is coupled to the calibration control cell 80. The delay matching cell 40 configured to perform delay matching processing on the calibration clock signal CLK_X to acquire the delay-matched clock signal CLK_PLL_MATCH. Wherein, the first edge of the delay-matched clock signal CLK_PLL_MATCH is aligned with the first edge of the calibration clock signal CLK_X, and the delay-matched clock signal CLK_PLL_MATCH has the same duty cycle as the calibration clock signal CLK_X.

Specifically, the delay matching cell 40 is a time delay unit. Those skilled in the art will understand that the delay matching cell may also be implemented through other structures with the same functions, which will not be limited herein.

In this embodiment, the phase-locked loop cell 60 is provided with a first input port, a second input port, a feedback signal port and output port. Wherein, the first input port of the phase-locked loop cell 60 is coupled to the duty cycle calibration cell 20, the second input port of the phase-locked loop cell 60 is coupled to the feedback signal port of the phase-locked loop cell 60, the output port of the phase-locked loop cell 60 configured to output the oscillation clock signal CLK_OUT.

The phase-locked loop cell 60 configured to perform phase-locked processing on the calibration clock signal CLK_X to acquire the oscillation clock signal CLK_OUT; Perform first frequency division processing on the oscillation clock signal CLK_OUT to acquire the feedback clock signal CLK_RING; wherein, when the phase-locked loop cell 60 is in the locked state, the first edge of the feedback clock signal CLK_RING is aligned with the first edge of the calibration clock signal CLK_X, and the feedback clock signal CLK_RING has the target duty cycle.

Specifically, the phase-locked loop cell 60 comprises: a phase-frequency detector block 601, a charge pump block 602, a loop filter block 603, a voltage-controlled oscillator block 604 and a first frequency divider block 605.Wherein:
The phase-frequency detector block 601 is provided with a first input port, a second input port, a first output port, and a second output port. Wherein, the first input port of the phase-frequency detector block 601 is used as the first input port of the phase-locked loop cell 60,the second input port of the phase-frequency detector block 601 is used as the second input port of the phase-locked loop cell 60, the first output port and second output port of the phase-frequency detector block 601 are respectively coupled to the charge pump block 602. The phase-frequency detector block 601 configured to acquire a phase difference signal according to the phase difference between the calibration clock signal CLK_X and the feedback clock signal CLK_RING.

The charge pump block 602 is provided with a first input port, a second input port and an output port. Wherein, the first input port of the charge pump block 602 is coupled to the first output port of the phase-frequency detector block 601, the second input port of the charge pump block 602 is coupled to the second output port of the phase-frequency detector block 601, the output port of the charge pump block 602 is coupled to the loop filter block 603. The charge pump block 602 configured to convert the phase difference signal into a current signal.

The loop filter block 603 is provided with an input port and an output port. Wherein, the input port of the loop filter block 603 is coupled to the output port of the charge pump block 602, the output port of the loop filter block 603 is coupled to the voltage-controlled oscillator block 604. The loop filter block 603 configured to perform low-pass filter processing on the current signal.

The voltage-controlled oscillator block 604 is provided with an input port and an output port. Wherein, the input port of the voltage-controlled oscillator block 604 is coupled to the output port of the loop filter block 603, the output port of the voltage-controlled oscillator block 604 is used as the output port of the phase-locked loop cell 60 or coupled to the output port of the phase-locked loop cell 60. The voltage-controlled oscillator block 604 configured to acquire an oscillation clock signal CLK_OUT according to the current signal. Wherein, the oscillation frequency of the oscillation clock signal CLK_OUT has a one-to-one correspondence relationship with the current signal.

The first frequency divider block 605 is provided with an input port and an output port. Wherein, the input port of the first frequency divider block 605 is coupled to the output port of the voltage-controlled oscillator block 604, the output port of the first frequency divider block 605 is used as the feedback signal port of the phase-locked loop cell 60 or coupled to the feedback signal port of the phase-locked loop cell 60. The first frequency divider block 605 configured to perform frequency division processing on the oscillation clock signal CLK_OUT to acquire the feedback clock signal CLK_RING.

As an example, the first frequency divider block 605 comprises a first frequency divider 6051 and a second frequency divider 6052.Wherein:
The first frequency divider 6051 is provided with an input port and an output port. Wherein, the input port of the first frequency divider 6051 is used as the input port of the first frequency divider block 605 or coupled to the input port of the first frequency divider block 605,the output port of the first frequency divider 6051 is coupled to the input port of the second frequency divider 6052. The first frequency divider 6051 configured to perform the first sub frequency division processing on the oscillation clock signal CLK_OUT to acquire the first frequency-divided signal.

The second frequency divider 6052 is provided with an input port and an output port. Wherein, the input port of the second frequency divider 6052 is coupled to the output port of the first frequency divider 6051,the output port of the second frequency divider 6052 is used as the output port of the first frequency divider block 605 or coupled to the output port of the first frequency divider block 605.The second frequency divider 6052 configured to perform the second sub frequency division processing on the first frequency-divided signal to acquire the feedback clock signal CLK_RING.

In specific embodiments, the first frequency divider 6051 is a step frequency divider with a step value of 1/2 ⁿ , and the second frequency divider 6052 is a frequency divider-by-2, wherein n is an integer. For example, when n=0, the first frequency divider 6051 is a step frequency divider with a step value of 1; when n=1, the first frequency divider 6051 is a step frequency divider with a step value of 0.5.

It should be noted that when the first frequency divider 6051 is a step frequency divider with a step value of 1, the frequency of the oscillation clock signal CLK_OUT output by the phase-locked loop cell 60 is an even multiple of the reference clock signal input to the phase-locked loop cell 60; when the first frequency divider 6051 is a step frequency divider with a step value of 1, the frequency of the oscillating clock signal CLK_OUT output by the phase-locked loop cell 60 is an odd multiple or even multiple of the reference clock signal input to the phase-locked loop cell 60.

The structure of the phase-locked loop cell described above is merely an example. It is understood that the phase-locked loop cell can also be implemented through other structures with the same functions, and those skilled in the art can set it according to actual needs, which will not be limited herein.

In this embodiment, the calibration control cell 80 is provided with a first input port, a second input port and a calibration control signal output port. Wherein, the first input port of the calibration control cell 80 is coupled to the output port of the delay matching cell 40,the second input port of the calibration control cell 80 is coupled to the feedback signal port of the phase-locked loop cell 60, the calibration control signal output port of the calibration control cell 80 is coupled to the calibration control port of the duty cycle calibration cell 20.The calibration control cell 80 configured to perform sampling processing on the delay-matched clock signal CLK_PLL_MATCH using the feedback clock signal CLK_RING to acquire the sampled signal when the phase-locked loop cell 60 is in the locked state; According to the sampled signal, generate the calibration control signal CORR_C.

Specifically, the calibration control cell 80 comprises a sampling block 801 and a control block 802.Wherein:
The sampling block 801 is provided with a first input port, a second input port and an output port. Wherein, the first input port of the sampling block 801 is used as the first input port of the calibration control cell 80 or coupled to the first input port of the calibration control cell 80, the second input port of the sampling block 801 is used as the second input port of the calibration control cell 80 or coupled to the second input port of the calibration control cell 80,the output port of the sampling block 801 is coupled to the control block 802. The sampling block 801 configured to perform sampling processing on the delay-matched clock signal CLK_PLL_MATCH using the feedback clock signal CLK_RING when the phase-locked loop cell 60 is in the locked state to acquire the sampled signal, the sampled signal is used to instruct the relationship between the duty cycle of the calibration clock signal CLK_X and the target duty cycle.

In this embodiment, the sampling block 801 is a D Flip-Flop. Wherein, the clock signal input port of the D Flip-Flop is used as the first input port of the sampling block 801 or coupled to the first input port of the sampling block 801,the data input port of the D Flip-Flop is used as the second input port of the sampling block 801 or coupled to the second input port of the sampling block 801,the data output port of the D Flip-Flop is used as the output port of the sampling block 801 or coupled to the output port of the sampling block 801. The D Flip-Flop configured to perform sampling processing on the delay-matched clock signal CLK_PLL_MATCH when the second edge of the feedback clock signal CLK_RING arrives to acquire the sampled signal.

The control block 802 is provided with an input port and a calibration signal output port. Wherein, the input port of control block 802 is coupled to the output port of the sampling block 801, the calibration signal output port of the control block 802 is used as the calibration signal output port of the calibration control cell 80 or coupled to the calibration signal output port of the calibration control cell 80. The control block 802 configured to generate the calibration control signal CORR_C according to the sampled signal.

Specifically, the control block 802 configured to acquire the sampled values of the sampled signal according to a preset control period; If the sampled values of the sampled signal within the control period are all the first value, then generate a calibration control signal CORR_C to instruct the duty cycle calibration cell 20 to increase the duty cycle of the calibration clock signal; If the sampled values of the sampled signal within the control period are all the second value, then generate a calibration control signal CORR_C to instruct the duty cycle calibration cell 20 to reduce the duty cycle of the calibration clock signal.

Those skilled in the art will understand that the calibration control cell may also be implemented through other structures with the same functions, which will not be limited herein.

In this embodiment, the control block 802 is a digital frequency multiplier with a low-pass filter.

In this embodiment, the target duty cycle is 50%, the first edge is the rising edge and the second edge is the falling edge. It should be noted that the target duty cycle can also be other values, the first edge can also be the falling edge, and the second edge can also be the rising edge, which will not be limited herein.

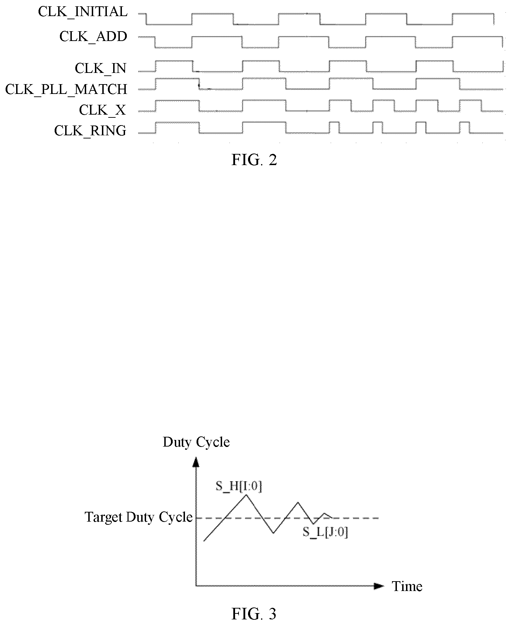

FIG. 2 is a waveform diagram of relevant signals in an embodiment of the duty cycle calibration circuit provided by the technical solution of the disclosure.

The following describes the working principle of the duty cycle calibration circuit in this embodiment reference to the FIG. 1 to FIG. 2.

Referring to FIG. 1 to FIG. 2, in the duty cycle calibration cell 20, when received the input clock signal CLK_SCIN , the first delay block 201 performs the first delay processing on the input clock signal CLK_SCIN to acquire the first delay clock signal, and the first OR operation block 202 performs an OR operation on the input clock signal CLK_SCIN and the first delay clock signal to acquire the summed clock signal CLK_ADD, thereby further increasing the duty cycle of the summed clock signal CLK_ADD, then the first inverter 203 performs an inversion processing on the summed clock signal CLK_ADD to acquire the inverted signal of the summed clock signal CLK_IN.

Next, in the duty cycle calibration cell 20, the second delay block 204 receives the inverted signal CLK_IN of the summed clock signal, and performs a second delay processing on the inverted signal CLK_IN of the summed clock signal according to the calibration control signal CORR_C, to acquire the second delay clock signal, then, the second OR operation block 205 performs an OR operation processing on the inverted signal CLK_IN of the summed clock signal and the second delay clock signal, to acquire the calibration clock signal CLK_X.

Therefore, according to the relationship between the actual duty cycle of the calibration clock signal CLK_X output by the duty cycle calibration cell 20 and the target duty cycle, generate the corresponding calibration control signal CORR_C to achieve real-time calibration of the duty cycle of the clock signal CLK_X.

Subsequently, using the delay matching cell 40, phase-locked loop cell 60 and calibration control cell 80 , can acquire the relationship between the actual duty cycle of the calibration clock signal CLK_X output by the duty cycle calibration cell 20 and the target duty cycle in real time, thereby generating the corresponding calibration control signal CORR_C to perform real-time calibration of the actual duty cycle of the calibration clock signal CLK_X.

Specifically, the delay matching cell 40 performs delay matching cell on the calibration clock signal CLK_X to acquire the delay-matched clock signal CLK_PLL_MATCH. Wherein, there is a corresponding delay between the phase of the delay-matched clock signal CLK_PLL_MATCH and the phase of the delay-matched clock signal CLK_PLL_MATCH, that enable the first edge of the delay-matched clock signal CLK_PLL_MATCH aligns with the first edge of the calibration clock signal CLK_X, and the delay-matched clock signal CLK_PLL_MATCH and the calibration clock signal CLK_X have the same duty cycle.

Meanwhile, in the phase-locked loop cell 60, using the phase-frequency detector block 601 to acquire the phase difference signal according to the phase difference between the calibration clock signal CLK_X and the feedback clock signal CLK_RING, and the charge pump block 602 converts the phase difference signal into a current signal, then using the loop filter block 603 to perform low-pass filter processing on current signal ,the current signal after low-pass filtering enters the voltage-controlled oscillator block 604, and the voltage-controlled oscillator block 604 acquires the oscillation clock signal CLK_OUT according to the current signal, the first frequency divider block 605 performs frequency division processing on the oscillation clock signal CLK_OUT output by the voltage-controlled oscillator block 604, to acquire the corresponding feedback clock signal CLK_RING. This process repeats until the phase-locked loop cell 60 enters the locked state.

Wherein, when the phase-locked loop cell 60 is in the locked state, the first edge of the feedback clock signal CLK_RING is aligned with the first edge of the calibration clock signal CLK_X, and the duty cycle of the feedback clock signal CLK_RING is the target duty cycle.

Correspondingly, the calibration control cell 80 utilizes the feedback clock signal CLK_RING output by the phase-locked loop cell 60 when in the locked state and the delay-matched clock signal CLK_PLL_MATCH output by the delay matching cell 40 , each having a relationship with the calibration clock signal CLK_X, through the second edge of the feedback clock signal CLK_RING output by the phase-locked loop cell 60 in the locked state to perform sampling on the delay-matched clock signal CLK_PLL_MATCH output by the delay matching cell 40, that can acquire the relationship between the duty cycle of the delay-matched clock signal CLK_PLL_MATCH and the target duty cycle of the feedback clock signal CLK_RING.

At the same time, since the duty cycle of the delay-matched clock signal CLK_PLL_MATCH is the same as the duty cycle of the calibration clock signal CLK_X, so the relationship between the duty cycle of the delay-matched clock signal CLK_PLL_MATCH and the target duty cycle of the feedback clock signal CLK_RING, that is to say the relationship between the duty cycle of the calibration clock signal CLK_X and the target duty cycle.

Therefore, the calibration control cell 80 uses the second edge of the feedback clock signal CLK_RING output by the phase-locked loop cell 60 in the locked state to perform sampling on the delay-matched clock signal CLK_PLL_MATCH output by the delay matching cell 40, that can acquire the relationship between the duty cycle of the calibration clock signal CLK_X and the target duty cycle, thereby according to the relationship between the duty cycle of the calibration clock signal CLK_X and the target duty cycle, generate the corresponding calibration control signal to the duty cycle calibration cell 20, that can calibrate the calibration clock signalCLK_X to the target duty cycle.

Specifically, the sampling block 801 uses the feedback clock signal CLK_RING to perform sampling on the delay-matched clock signal CLK_PLL_MATCH to acquire the corresponding sampled signal; the control block 802 through sampled signal to determine the relationship between the duty cycle of the calibration clock signal CLK_X and the target duty cycle, and according to the relationship between the duty cycle of the calibration clock signal CLK_X and the target duty cycle, generate the corresponding calibration control signal to the duty cycle calibration cell 20, that can calibrate the calibration clock signalCLK_X to the target duty cycle.

Please refer to FIG. 2, taking the first edge as the rising edge and the second edge as the falling edge as an example, the rising edge of the delay-matched clock signal CLK_PLL_MATCH is aligned with the rising edge of the feedback clock signal CLK_RING, and the feedback clock signal CLK_RING has the target duty cycle. Therefore, using the falling edge of the feedback clock signal CLK_RING performs sampling on the delay-matched clock signal CLK_PLL_MATCH, and the sampled values of the acquired sampled signal may have the following three cases:
1) If the duty cycle of the delay-matched clock signal CLK_PLL_MATCH is the target duty cycle, then using the falling edge of the feedback clock signal CLK_RING to perform sampling on the delay-matched clock signal CLK_PLL_MATCH, and the sampled values of the acquired sampled signal may be either the first value or the second value.
2) If the duty cycle of the delay-matched clock signal CLK_PLL_MATCH is less than the target duty cycle, then using the falling edge of the feedback clock signal CLK_RING to perform sampling on the delay-matched clock signal CLK_PLL_MATCH, and the sampled values of the acquired sampled signal are all the first value.
3) If the duty cycle of the delay-matched clock signal CLK_PLL_MATCH is greater than the target duty cycle, then using the falling edge of the feedback clock signal CLK_RING to perform sampling on the delay-matched clock signal CLK_PLL_MATCH, and the sampled values of the acquired sampled signal are all the second value.

Wherein, the first value is 10, and the second value is 11.

Correspondingly, when the sampled values of the sampled signals acquired by control block 802 according to the preset control period are all the first value, that can determine the duty cycle of the clock signal is less than the target duty cycle, at this time, output the corresponding calibration control signal CORR_C, and enable the duty cycle calibration cell 20 to increase the duty cycle of the calibration clock signal CLK_X; when the sampled values of the sampled signals acquired according to the preset control period are all the second value, that can determine the duty cycle of the calibration clock signal CLK_X is greater than the target duty cycle, at this time, output the corresponding calibration control signal CORR_C, and enable the duty cycle calibration cell 20 to decrease the duty cycle of the calibration clock signal CLK_X; when the average of the sampled values of the sampled signals acquired according to the preset control period is the average value of the first value and the second value, that can determine the duty cycle of the calibration clock signal CLK_X is greater than the target duty cycle, at this time, output the corresponding calibration control signal CORR_C, and enable the duty cycle calibration cell 20 to maintain the duty cycle of the calibration clock signal CLK_X unchanged.

Referring to FIG. 3, in this embodiment, the calibration control signal CORR_C1 output by the control block 802 comprises multiple coarse adjustment step control signals S_H[I:0] one-to-one corresponding to multiple coarse adjustment steps and multiple fine adjustment step control signals S_L[J:0] one-to-one corresponding to multiple fine adjustment steps. Wherein, I and J are integers greater than or equal to 1, and the step interval between adjacent coarse adjustment step is greater than the step interval between adjacent fine adjustment step.

The control block 802 first outputs the coarse adjustment step control signals S_H[I:0], that enable the duty cycle calibration cell 20 to perform duty cycle calibration processing on the input clock signal CLK_SCIN according to the coarse adjustment step control signals S_H[I:0],until the duty cycle of the output calibration clock signal CLK_X oscillates back and forth around the target duty cycle; Afterwards, outputs the fine adjustment step control signal S_L[J:0], that enable the duty cycle calibration cell 20 to perform duty cycle calibration processing on the input clock signal CLK_SCIN according to the fine adjustment step control signals S_L[J:0],until the duty cycle of the output calibration clock signal CLK_X reaches the target duty cycle.

Firstly, using the coarse adjustment step control signals S_H[I:0] to perform duty cycle calibration processing, that enable the duty cycle of the calibration clock signal CLK_X converges to a smaller range, then using the fine adjustment step control signals S_L[J:0] to perform duty cycle calibration processing within this smaller range, that can enable the duty cycle of the calibration clock signal CLK_X to reach the target duty cycle quickly, and improve the speed of duty cycle calibration processing, reduce calibration time, and help improve the calibration speed and efficiency of the duty cycle calibration circuit in the embodiments of the disclosure.

In this embodiment, the control block 802 further configured to perform duty cycle calibration processing on the input clock signal CLK_SCIN according to the calibration control signal CORR_C, until when until the duty cycle of the calibration clock signal CLK_X reaches a target duty cycle to acquire and store the corresponding coarse adjustment calibration control signals S_H[I:0] and the corresponding fine adjustment calibration control signals S_L[J:0],and further configured to transmit the stored coarse adjustment calibration control signals S_H[I:0] and the fine adjustment calibration control signals S_L[J:0] to the duty cycle calibration cell 20 when received a wake-up signal.

Correspondingly, the duty cycle calibration cell 20 further configured to calibrate the duty cycle of the calibration clock signal CLK_X to the target duty cycle according to the received coarse adjustment calibration control signals S_H[I:0] and the fine adjustment calibration control signals S_L[J:0] when received the coarse adjustment calibration control signals S_H[I:0] and the fine adjustment calibration control signals S_L[J:0] sent by the control block 802.

In this embodiment, the corresponding coarse adjustment calibration control signals S_H[I:0],refers to during the process of performing duty cycle calibration processing on the input clock signal CLK_SCIN according to the coarse adjustment calibration control signals S_H[I:0],that enable when the duty cycle of the output calibration clock signal CLK_X oscillates back and forth near the target duty cycle, corresponding to the coarse adjustment calibration control signals S_H[I:0];the corresponding fine adjustment calibration control signals S_L[J:0], refers to during the process of performing duty cycle calibration processing on the input clock signal CLK_SCIN according to the fine adjustment calibration control signal S_L[J:0] after the duty cycle of the output calibration clock signal CLK_X oscillates back and forth around the target duty cycle, that enable when the duty cycle of the output calibration clock signal CLK_X reaches the target duty cycle, corresponding to the fine adjustment calibration control signals S_L[J:0].

Correspondingly, when the control block 802 received a wake-up signal, it transmit the stored coarse adjustment calibration control signal S_H[I:0] and fine adjustment calibration control signal S_L[J:0] to the duty cycle calibration cell 20, that can enable the duty cycle calibration cell 20 to directly calibrate the duty cycle of the calibration clock signal CLK_X to the target duty cycle according to the corresponding coarse adjustment calibration control signal S_H[I:0] and fine adjustment calibration control signal S_L[J:0], thereby bypassing previous other processing steps and help improve calibration speed. At the same time, performing the duty cycle adjusting on the input clock signal CLK_SCIN only during the wake-up phase, which help minimize power consumption.

It should be noted that in this embodiment, the phase-locked loop cell 60 further comprises: a third frequency divider block 606, configured to perform third frequency division processing on the oscillation clock signal CLK_OUT to acquire a third frequency-divided signal.

In this embodiment, the third frequency divider block 6061 is provided with an input port and an output port. Wherein, the input port of the third frequency divider block 606 is coupled to the output port of the voltage-controlled oscillator cell 605, the output port of the third frequency divider block 606 is coupled to the timing control block 803. The third frequency divider block 606 configured to perform third frequency division processing on the oscillation clock signal CLK_OUT to acquire the third frequency-divided signal.

Correspondingly, the calibration control cell 80 further comprises: a timing control block 803, configured to perform a third delay processing on the delay-matched clock signal CLK_PLL_MATCH according to the third frequency-divided signal to acquire the timing control signal CLK_DIG, the frequency of the timing control signal CLK_DIG is higher than the frequency of the feedback clock signal CLK _RING, and the phase of the timing control signal CLK_DIG lags behind the phase of the feedback clock signal CLK_RING.

Specifically, the timing control block 803 is a time delay unit.

Correspondingly, the control block 802 further configured to control the output timing of the calibration control signal CORR_C according to the timing control signal CLK-DIG.

The frequency of the timing control signal CLK_DIG is higher than the frequency of the feedback clock signal CLK_RING, and the phase of the timing control signal CLK_DIG lags behind the phase of the feedback clock signal CLK _RING, that can enable the arrival time of the rising edge of the timing control signal CLK_DIG is much slower than the arrival time of the rising edge of the delay-matched clock signal CLK_PLL_MATCH, thereby using the timing control signal CLK_DIG to control the output timing of the calibration control signal CORR_C, which improves the accuracy of the output calibration control signal CORR_C and further helps achieve the accurate control of the duty cycle calibration cell 20.

The duty cycle calibration circuit in this embodiment of the disclosure can perform real-time calibration of the duty cycle of the calibration clock signal CLK_X, enable the duty cycle of the calibration clock signal CLK_X to meet the target duty cycle, that can improve the accuracy of the generated calibration clock signal CLK_X, thereby enabling the subsequent frequency-multiplied clock signal generated based on the calibration clock signal CLK_X to have a single cycle, thereby can improve the accuracy of the generated frequency-multiplied clock signal, further helps improve the quality of wireless communication.

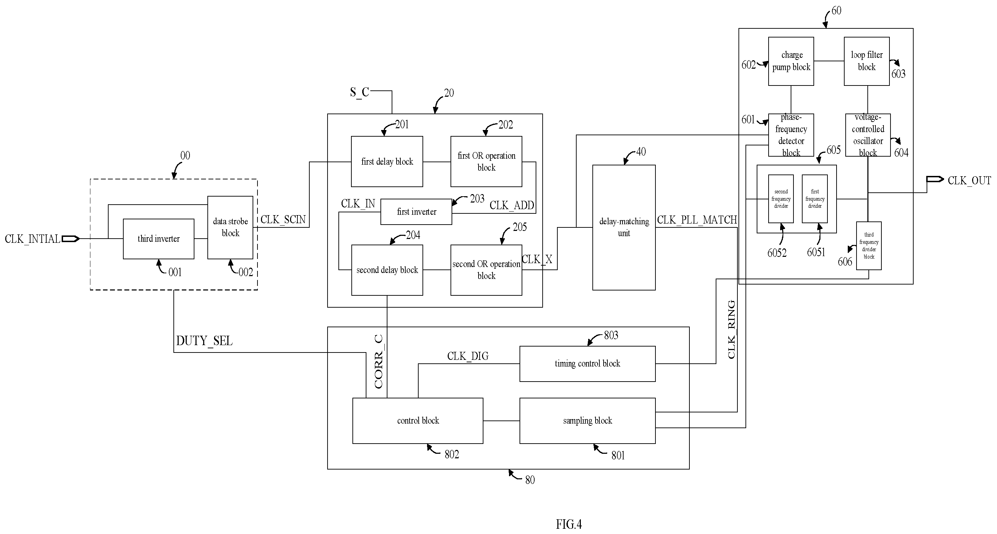

FIG. 4 is a circuit structure diagram in another embodiment of the duty cycle calibration circuit provided by the technical solution of the disclosure. The similarities between this embodiment and the first embodiment are not repeated here. The differences between this embodiment and the aforementioned embodiment are as follows: the duty cycle calibration circuit also comprises a signal selection circuit 00.

In this embodiment, signal selection cell 00 is provided with an control port, an input port and an output port. Wherein, the control port of signal selection cell 00 is coupled to calibration control cell 80, the input port of signal selection cell 00 is used to receive the initial clock signal CLK_INITIAL, and the output port of signal selection cell 00 is coupled to duty cycle calibration cell 20.

The signal selection cell 00 configured to perform duty cycle calibration processing on the input clock signal CLK_SCIN according to the calibration control signal CORR_C, until before the duty cycle of the output calibration control signal CLK_X reaches the target duty cycle, according to the duty cycle selection control signal DUTY_SEL, outputting the initial clock signal CLK_INITIAL with a output duty cycle greater than the target duty cycle or the inverted signal of the initial clock signal CLK_INITIAL as the input clock signal;

Specifically, the signal selection cell 00 comprises a third inverter 001 and a data strobe block 002.Wherein:
The third inverter 001 is provided with an input port and an output port. Wherein, the input port of the third inverter 001 is used as the input port of the signal selection cell 00 or coupled to the input port of the signal selection cell 00, the output port of the third inverter 001 is coupled to the data strobe block 002. The third inverter 001 configured to perform the first inversion processing on the initial clock signal CLK_INITIAL to acquire the inverted signal of the initial clock signal CLK_INITIAL.

The data strobe block 002 is provided with a control port, a first input port, a second input port and an output port. Wherein, the control port of the data strobe block 002 is used as the control port of signal selection cell 00 or coupled to the control port of signal selection cell 00,the first input port of the data strobe block 002 is used as the input port of signal selection cell 00 or coupled to the input port of signal selection cell 00,the second input port of the data strobe block 002 is coupled to the output port of the third inverter 001, the output port of the data strobe block 002 is used as the output port of the signal selection cell 00 or coupled to the output port of the signal selection cell 00. Data strobe block 002 configured to select the signal with a duty cycle greater than the target duty cycle from the initial clock signal CLK_INITIAL and the inverted signal of the initial clock signal as the input clock signal CLK_SCIN and output it according to duty cycle selection control signal DUTY_SEL.

In other embodiments, the signal selection cell may also be implemented through other structures with the same functions. Those skilled in the art may select according to actual needs, which will not be limited herein.

Correspondingly, the calibration control cell 80 further configured to generate a mode selection control signal S_C with a first logic level before generating the duty cycle selection control signal DUTY_SEL; and to generate a mode selection control signal S_C with a second logic level after generating the duty cycle selection control signal DUTY_SEL, wherein the second logic level is different from the first logic level.

Correspondingly, the duty cycle calibration cell 20 configured to perform duty cycle calibration processing on the input clock signal CLK_SCIN according to the calibration control signal CORR_C when the mode selection control signal DUTY_SEL has a second logic level, until the duty cycle of the output calibration control signal CLK_X reaches the target duty cycle; and further configured to pass the initial clock signal CLK_INITIAL through to the phase-locked loop cell 60 and the delay matching cell 40 when the mode selection control signal DUTY_SEL has a first logic level.

In this embodiment, after the duty cycle calibration cell 20 pass the initial clock signal CLK_INITIAL through to the delay matching cell 40 and the phase-locked loop cell 60, using the delay matching cell 40, the phase-locked loop cell 60 and the calibration control cell 80 also to acquire the relationship between the duty cycle of the initial clock signal CLK_INITIAL and the target duty cycle, thereby generating a corresponding duty cycle selection control signal DUTY_SEL according to the relationship between the duty cycle of the initial clock signal CLK_INITIAL and the target duty cycle, and outputting it to the signal selection cell 00,that enable the signal selection cell 00 to select output the initial clock signal CLK_INITIAL with a duty cycle greater than the target duty cycle, or the inverted signal of the initial clock signal CLK_INITIAL as the input clock signal CLK_SCIN according to the duty cycle selection control signal DUTY_SEL. Specifically:
The delay matching cell 40 further configured to perform initial delay matching processing on the initial clock signal CLK_INITIAL to acquire the initial delay-matched signal, the first edge of the initial delay-matched clock signal is aligned with the first edge of the initial clock signal, and the delay-matched clock signal has the same duty cycle as the initial clock signal CLK_INITIAL.

The phase-locked loop cell 60 further configured to perform phase-locked processing on the initial clock signal CLK_INITIAL to acquire the initial oscillation clock signal, to perform frequency division processing on the initial oscillation clock signal to acquire the initial feedback clock signal; when the phase-locked loop cell is in the locked state, the first edge of the initial feedback clock signal is aligned with the first edge of the initial delay-matched clock signal and has the target duty cycle.

The calibration control cell 80 further configured to perform initial sampling processing on the initial delay-matched clock signal using the initial feedback clock signal when the phase-locked loop cell 60 is in the locked state, to acquire the initial sampled signal. The initial sampled signal is used to instruct the relationship between the duty cycle of the initial clock signal and the target duty cycle; According to the initial sampled signal, generate the duty cycle selection control signal DUTY_SEL.

Regarding the process of using the delay matching cell 40, phase-locked loop cell 60 and calibration control cell 80 to acquire the relationship between the duty cycle of the initial clock signal and the target duty cycle , and generating the corresponding duty cycle selection control signal according to the relationship between the duty cycle of the initial clock signal CLK_INITIAL and the target duty cycle, can refer to the aforementioned embodiment process that using the delay matching cell 40, phase-locked loop cell 60 and calibration control cell 80 to acquire the relationship between the duty cycle of the calibration clock signal and the target duty cycle ,and generating the corresponding calibration control signal CORR_C according to the relationship between the duty cycle of the calibration clock signal CLK_X and the target duty cycle to execute . This process will not be repeated here.

It should be noted that the duty cycle calibration circuit in this embodiment, using signal selection cell 00 according to select the duty cycle selection control signal DUTY_SEL to transmit the initial clock signal CLK_INITIAL with a duty cycle greater than the target duty cycle or the inverted version of the initial clock signal CLK_INITIAL to the duty cycle calibration cell 20. Subsequently, in the duty cycle calibration circuit 20,increase the duty cycle and invert , that enable the duty cycle of the inverted signal CLK_IN of the summed clock signal entering the second delay block 204 is less than the target duty cycle, and has a larger adjustment margin, to provide the foundation for subsequent continuous adjustment toward increasing the duty cycle of the inverted signal CLK_IN of the summed clock signal, until the output calibration clock signal CLK_X reaches the target duty cycle.

It should also be noted that in other embodiment, also can enable the duty cycle of the inverted signal CLK_IN of the summed clock signal greater than the target duty cycle, and continuous adjustment toward reducing the duty cycle of the inverted signal CLK_IN of the summed clock signal, until the output calibration clock signal CLK_X reaches the target duty cycle.

In this embodiment, the calibration control cell 80 further configured to convert the logic level of the duty cycle selection control signal DUTY_SEL from the second logic level to first logic level when determine that the duty cycle of the initial clock signal CLK_INITIAL is greater than the target duty cycle and the duty cycle selection control signal DUTY_SEL has a second logic level, and waiting for the phase-locked loop cell 60 reenters the initial locking state, convert the logic level of the mode selection control signal S_C from the first logic level to the second logic level.

When determine that the duty cycle of the initial clock signal CLK_INITIAL is greater than the target duty cycle and the duty cycle selection control signal DUTY_SEL has a second logic level, the calibration control cell 80 converts the logic level of the duty cycle selection control signal DUTY_SEL from the second logic level to first logic level may cause jitter in the initial clock signal CLK_INITIAL input to the phase-locked loop cell 60. Therefore, waiting for the phase-locked loop cell 60 reenters the initial locking state, can enable the first edge of the initial feedback clock signal output by the phase-locked loop cell 60 to realign with the first edge of the initial clock signal CLK_INITIAL. At this time, converting the logic level of the mode selection control signal S_C from the first logic level to the second logic level, thereby entering the calibration phase of the input clock signal CLK_SC.

Correspondingly, a duty cycle calibration method is also provided in the embodiments of the disclosure.

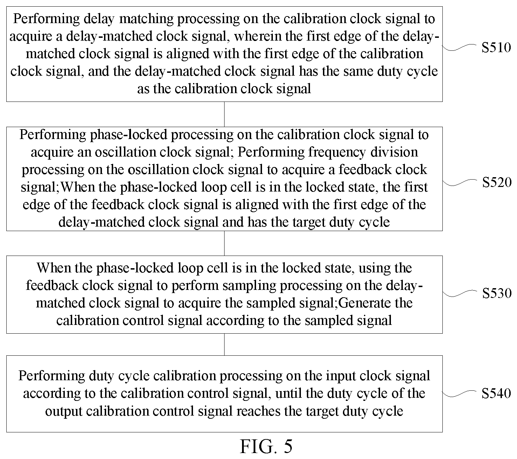

FIG. 5 is a schematic flowchart in an embodiment of a duty cycle calibration method provided by the technical solution of the disclosure. Refer to FIG. 5, specifically comprises the following steps:
S510: Performing delay matching processing on the calibration clock signal to acquire a delay-matched clock signal, wherein the first edge of the delay-matched clock signal is aligned with the first edge of the calibration clock signal, and the delay-matched clock signal has the same duty cycle as the calibration clock signal;
S520: Performing phase-locked processing on the calibration clock signal to acquire an oscillation clock signal; Performing frequency division processing on the oscillation clock signal to acquire a feedback clock signal; When the phase-locked loop cell is in the locked state, the first edge of the feedback clock signal is aligned with the first edge of the delay-matched clock signal and has the target duty cycle;
S530: When the phase-locked loop cell is in the locked state, using the feedback clock signal to perform sampling processing on the delay-matched clock signal to acquire the sampled signal; Generate the calibration control signal according to the initial sampled signal;
S540: Performing duty cycle calibration processing on the input clock signal according to the calibration control signal, until the duty cycle of the output calibration control signal reaches the target duty cycle.

The duty cycle calibration circuit in the embodiments of the disclosure can be used to perform the duty cycle calibration method in the embodiments of the disclosure, or other functional modules can also be used to perform the duty cycle calibration method in the embodiments of the disclosure. About the duty cycle calibration method in the embodiments of the disclosure, please refer to the detailed descriptions in the preceding section, which will not be repeated herein.

Correspondingly, a clock multiplier circuit is further provided in an embodiment of the disclosure, the clock multiplier circuit comprises the duty cycle calibration circuit provided in the embodiments of the disclosure.

When the duty cycle of the calibration clock signal reaches 50%, the clock multiplier circuit in the embodiments of the disclosure can overcome the duty cycle offset of the calibration clock signal caused by operating temperature and can maintain the duty cycle of the calibration clock signal at 50%, that enable the frequency-multiplied clock signal generated based on the calibration clock signal to have a single time period, thereby can improve the accuracy of the generated frequency-multiplied clock signal, consequently help improve the quality of wireless communication.

About the duty cycle calibration circuit in the embodiments of the disclosure, please refer to the detailed descriptions in the preceding section, which will not be repeated herein.

Although the embodiments of the disclosure are disclosed above, the disclosure is not limited thereto. Those skilled in the art can make various alterations and modifications without departing from the spirit and scope of the disclosure. Therefore, the scope of protection of the disclosure should be subject to the scope defined in the claims.

## Claims

1. A duty cycle calibration circuit, comprising:
a duty cycle calibration cell, configured to perform duty cycle calibration processing on the input clock signal according to the calibration control signal, until the duty cycle of the output calibration clock signal reaches the target duty cycle;
a delay matching cell, configured to perform delay matching processing on the calibration clock signal to acquire a delay-matched clock signal, the first edge of the delay-matched clock signal is aligned with the first edge of the calibration clock signal, and the delay-matched clock signal has the same duty cycle as the calibration control signal;
a phase-locked loop cell, configured to perform phase-locked processing on the calibration clock signal to acquire oscillating clock signal; and to perform frequency division processing on the oscillating clock signal to acquire feedback clock signal; when the phase-locked loop cell is in the locked state, the first edge of the feedback clock signal is aligned with the first edge of the delay-matched clock signal, and the feedback clock signal has the target duty cycle;
a calibration control cell, configured to perform sampling processing on delay-matched clock signal using the feedback clock signal to acquire the sampled signal when the phase-locked loop cell is in the locked state; According to the sampled signal, generate the calibration control signal.

2. The duty cycle calibration circuit according to claim 1, wherein the duty cycle calibration cell comprises:
a first delay block, configured to perform the first delay processing on the input clock signal to acquire a first delay clock signal;
a first OR operation block, configured to perform OR operations processing on the input clock signal and the first delay clock signal to acquire the summed clock signal;
a first inverter, configured to perform inversion processing on the summed clock signal to acquire the inverted signal of the summed clock signal;
a second delay block, configured to perform a second delay processing on the inverted signal of the summed clock signal according to calibration control signal to acquire a second delay clock signal;
a second OR operation block, configured to perform OR operation processing on the inverted signal of the summed clock signal and the second delay clock signal to acquire the calibration clock signal.

3. The duty cycle calibration circuit according to claim 1, wherein the phase-locked loop cell comprises:
a phase-frequency detector block, configured to acquire the phase difference signal according to the phase difference between the calibration clock signal and the feedback clock signal;
a charge pump block, configured to convert the phase difference signal into a current signal;
a loop filter block, configured to perform low-pass filter processing on the current signal;
a voltage-controlled oscillator block, configured to acquire oscillation clock signal according to the current signal;
a first frequency divider block, configured to perform frequency division processing on the oscillating clock signal to acquire the feedback clock signal.

4. The duty cycle calibration circuit according to claim 3, wherein the first frequency divider block comprises:
a first frequency divider, configured to perform the first sub frequency division processing on the oscillating clock signal to acquire the first frequency-divided signal;
a second frequency divider, configured to perform the second sub frequency division processing on the first frequency-divided signal to acquire the feedback clock signal.

5. The duty cycle calibration circuit according to claim 1, wherein the calibration control cell comprises:
a sampling block, configured to perform sampling processing on the delay-matched clock signal using the feedback clock signal when the phase-locked loop cell is in the locked state to acquire the sampled signal;
a control block, configured to generate the calibration control signal according to the sampled signal.

6. The duty cycle calibration circuit according to claim 1, wherein the first edge is a rising edge, and a second edge is a falling edge.

7. The duty cycle calibration circuit according to claim 5, wherein the control block is configured to acquire the sampled values of the sampled signal according to a preset control period; if the sampled values of the sampled signal within the control period are all the first value, then generate a calibration control signal to instruct the duty cycle calibration cell to increase the duty cycle of the calibration clock signal; if the sampled values of the sampled signal within the control period are all the second value, then generate a calibration control signal to instruct the duty cycle calibration cell to reduce the duty cycle of the calibration clock signal.

8. The duty cycle calibration circuit according to claim 5, wherein the calibration control signal comprises:
multiple coarse adjustment step control signals corresponding to multiple coarse adjustment steps and multiple fine adjustment step control signals corresponding to multiple fine adjustment steps, and the step interval between adjacent coarse adjustment step is greater than the step interval between adjacent fine adjustment step;
the control block is configured to generate a coarse adjustment step control signal corresponding to the coarse adjustment step according to the sampled signal and output it to the duty cycle calibration cell, until the duty cycle of the calibration clock signal oscillates back and forth near the target duty cycle; and further configured to generate a coarse adjustment step control signal corresponding to the fine adjustment step according to the sampled signal and output it to the duty cycle calibration cell after the duty cycle of the calibration clock signal oscillates back and forth around the target duty cycle, until the duty cycle of the calibration clock signal reaches the target duty cycle.

9. The duty cycle calibration circuit according to claim 8, wherein the control block is further configured to perform duty cycle calibration processing on the input clock signal according to the calibration control signal, that when the duty cycle of the output calibration control signal reaches the target duty cycle to acquire and store the corresponding coarse adjustment calibration control signal and the corresponding fine adjustment calibration control signal; and further configured to transmit the stored coarse adjustment calibration control signal and fine adjustment calibration control signal to the duty cycle calibration cell when receiving a wake-up signal;
the duty cycle calibration cell, further configured to calibrate the duty cycle of the calibration clock signal to the target duty cycle according to the received coarse adjustment calibration control signal and fine adjustment calibration control signal, when receiving the coarse adjustment calibration control signal and fine adjustment calibration control signal sent by the calibration control cell.

10. The duty cycle calibration circuit according to claim 5, wherein the phase-locked loop cell, further comprises: a third frequency divider block, configured to perform the third frequency division processing on the oscillation clock signal to acquire a third frequency-divided signal;
the calibration control cell, further comprises: a timing control block, configured to perform a third delay processing on the delay-matched clock signal according to the third frequency-divided signal to acquire a timing control signal, the frequency of the timing control signal is higher than the frequency of the feedback clock signal, and the phase of the timing control signal lags behind the phase of the feedback clock signal; control the output timing of the calibration control signal according to the timing control signal;
the control block, further configured to control the output timing of the calibration control signal according to the timing control signal.

11. The duty cycle calibration circuit according to any one of the claims 1 to 10, wherein it further comprises:
a signal selection cell, configured to perform duty cycle calibration processing on the input clock signal according to the calibration control signal, until before the duty cycle of the output calibration control signal reaches the target duty cycle, according to the duty cycle selection control signal, selecting the initial clock signal with a output duty cycle greater than the target duty cycle or the inverted signal of the initial clock signal as the input clock signal;
the delay matching cell, further configured to perform initial delay matching processing on the initial clock signal to acquire an initial delay-matched signal, wherein the first edge of the initial delay-matched clock signal is aligned with the first edge of the initial clock signal, and the delay-matched clock signal has the same duty cycle as the initial clock signal;
the phase-locked loop cell, further configured to perform phase-locked processing on the initial clock signal to acquire the initial oscillation clock signal, perform frequency division processing on the initial oscillation clock signal to acquire the initial feedback clock signal; when the phase-locked loop cell is in the locked state, the first edge of the initial feedback clock signal is aligned with the first edge of the initial delay-matched clock signal and has the target duty cycle;
the calibration control cell, further configured to perform initial sampling processing on the initial delay-matched clock signal using the initial feedback clock signal when the phase-locked loop cell is in the locked state, to acquire an initial sampled signal, wherein the initial sampled signal is used to instruct the relationship between the duty cycle of the initial clock signal and the target duty cycle; and according to the initial sampled signal, generate the duty cycle selection control signal.

12. The duty cycle calibration circuit according to claim 11, wherein the calibration control cell is further configured to generate a mode selection control signal with a first logic level before generating the duty cycle selection control signal, and to generate a mode selection control signal with a second logic level after generating the duty cycle selection control signal, wherein the second logic level is different from the first logic level;
the duty cycle calibration cell, configured to perform duty cycle calibration processing on the input clock signal according to the calibration control signal when the mode selection control signal has a second logic level, until the duty cycle of the output calibration control signal reaches the target duty cycle; and further configured to pass the initial clock signal through to the phase-locked loop cell and the delay matching cell when the mode selection control signal has a first logic level.

13. The duty cycle calibration circuit according to claim 11, wherein the signal selection cell comprises:
a first inverter, configured to perform a first inversion processing on the initial clock signal to acquire an inverted signal of the initial clock signal;
a multiplexer, configured to select a signal with a duty cycle greater than the target duty cycle from the initial clock signal and the inverted signal of the initial clock signal as the input clock signal and output it according to a preset duty cycle selection control signal.

14. A duty cycle calibration method, comprising:
performing delay matching processing on the calibration clock signal to acquire a delay-matched clock signal, wherein the first edge of the delay-matched clock signal is aligned with the first edge of the calibration clock signal, and the delay-matched clock signal has the same duty cycle as the calibration clock signal;
performing phase-locked processing on the calibration clock signal to acquire an oscillation clock signal; performing frequency division processing on the oscillation clock signal to acquire a feedback clock signal; when the phase-locked loop cell is in the locked state, the first edge of the feedback clock signal is aligned with the first edge of the delay-matched clock signal and has the target duty cycle;
when the phase-locked loop cell is in the locked state, using the feedback clock signal to perform sampling processing on the delay-matched clock signal to acquire the sampled signal; Generate the calibration control signal according to the sampled signal;
performing a duty cycle calibration processing on the input clock signal according to the calibration control signal, until the duty cycle of the output calibration control signal reaches the target duty cycle.

15. A clock multiplier circuit, wherein comprising any one of the duty cycle calibration circuits described in claims 1 to 13.
